# EUROPEAN PATENT APPLICATION

(11) **EP 4 556 922 A1**
(43) Date of publication of application: **21.05.2025**
(21) Application number: 23209578.6
(22) Date of filing: 14.11.2023
(51) Int. Cl.: G01R 31/3835, G01R 31/36, G01R 31/392, H02J 7/00, H02J 9/06

(54) **DEVICE AND METHOD FOR TESTING A LIFE-TIME OF A BATTERY BEING AN EMERGENCY ELECTRICAL ENERGY STORAGE OF AN EMERGENCY LIGHTING SYSTEM**

(71) Applicant: Tridonic GmbH & Co. KG, 6851 Dornbirn (AT)
(72) Inventor: Shukla, Jagjitpati, 6851 Dornbirn (AT); Makwana, Deepak, 6851 Dornbirn (AT)
(74) Representative: Beder, Jens

(57) **Abstract**

The invention relates to an entity (1) for testing a life-time of a battery (3) being an emergency electrical energy storage of an emergency lighting system (2), wherein the entity (1) is configured to perform the following testing steps: triggering charging of the battery (3) having a voltage smaller than a first voltage threshold (VT1), determining a time interval between a first point in time, at which the voltage of the battery exceeds the first voltage threshold (VT1), and a second point in time, at which the voltage of the battery reaches a second voltage threshold (VT2) being greater than the first voltage threshold (VT1), and determining a remaining battery capacity of the battery (3) using the determined time interval and an initial value of the time interval. Further, the invention relates to an emergency lighting system comprising such an entity and method for testing a life-time of a battery.

## Description

The invention relates to an entity and a method for testing a life-time of a battery being an emergency electrical energy storage of an emergency lighting system. The invention further relates to an emergency lighting system comprising such an entity.

Emergency lighting systems comprise a battery as an emergency electrical energy storage in order to be able to provide a lighting (emergency lighting) in case that an electrical supply from mains is disturbed, e.g. completely interrupted or too low for a sufficient electrical energy supply. Mains failure may be due to local disturbance of the electrical energy supply in a building, e.g. in case of a fire, or to global disturbance of mains, e.g. due to failure of a power plant. An emergency lighting system may be for example an emergency luminaire, an emergency lighting driver, or a system comprising multiple emergency luminaires.

The emergency lighting system may be configured to detect a disturbance of the electrical energy supply from mains, such as mains failure, and in response thereto switch from a normal operation state to an emergency operation state. The term "normal operation mode" and "emergency operation mode" may be used as synonyms for the terms "normal operation state" and "emergency operation state", respectively. In the emergency operation state, the emergency lighting system is configured to provide lighting (i.e. emergency lighting) using electrical energy stored in the battery. That is, the electrical energy supply is independent from mains in the emergency operation state. In the normal operation state, the emergency lighting system may either emit light (in case the emergency lighting system is also used for providing normal lighting outside an emergency situation) or emit no light (in case the emergency lighting system is only used for emergency lighting).

In the normal operation state, i.e. when the electrical energy supply from mains is not disturbed, the battery of the emergency lighting system may be charged using electrical energy from mains in order to be fully charged and ready for supplying electrical energy in the emergency operation state. For this, the emergency lighting system may comprise a charging circuit that is configured to charge the battery using the electrical energy provided to the emergency lighting system from mains. The battery of the emergency lighting system may be referred to as "rechargeable battery".

In order to make sure that the emergency lighting system functions properly in the emergency operation state, the battery may be tested. For example, two tests may be performed. A first test, which may be called function test, may test whether an electrical energy supply from the battery works. A second test, which may be called duration test, may test whether an electrical energy supply from the battery works for a desired time. This desired time is usually determined by safety regulations, such as national or international regulations, and correspond to a time during which the emergency lighting system should be able to provide emergency lighting in case of mains disturbance. That is, the desired time corresponds to the time during which the battery should be able to provide an electrical energy supply to allow the emergency lighting of the emergency lighting system to occur. Thus, during the duration test, the emergency lighting system is operated for the desired time in the emergency operation state, i.e. the battery of the emergency lighting system is used during the desired time to electrically supply the lighting provided by the emergency lighting system. Thus, during the duration test the battery is discharged.

Over time the battery capacity of the battery, that is the amount of electrical energy storable by the battery, decreases. This is called aging of the battery. This may be due to environmental influences, such as temperature changes, the characteristics of the battery, e.g. materials used in the battery, operation of the emergency lighting system, e.g. amount of times and/or how battery is charged, etc.

In order to ensure that the battery of the emergency lighting system has a battery capacity that is sufficient for providing an electrical energy supply during the emergency operation state, i.e. during a time during which the emergency lighting system should be able to provide emergency lighting, a life-time testing of the battery may be performed. Such a life-time testing of the battery may determine a current battery capacity of the battery and, thus, a current life-time of the battery. In other words, testing the life-time of the battery corresponds to testing a remaining battery capacity of the battery because the remaining battery capacity determines whether the battery may be used as emergency electrical energy storage. In other words, when the battery capacity of the battery is not sufficient anymore for providing an emergency electrical energy storage of the emergency lighting system, the life-time of the battery may be said to have ended. For example, as soon as the battery capacity falls below a threshold for the battery capacity and, thus, is not able anymore to provide an electrical energy supply for a time sufficient for an emergency operation state of the emergency lighting system the life-time of the battery may be said to have ended, i.e. to be zero. In this case, the battery is to be replaced in order to allow a proper emergency operation of the emergency lighting system.

The current life-time of the battery may be measured by a percentage reduction of the battery capacity with regard to an initial value of the battery capacity. In this case, the life-time of the battery may be said to have ended when the percentage reduction of the battery capacity with regard to the initial value of the battery capacity has increased above a threshold for the percentage reduction.

One method for determining the life-time of a battery uses the profile of exponential decrease of a charging current during the constant voltage charging phase of charging the battery, which changes over time. A change in the exponential decrease of the charging current over time may be recognized and based on this it may be concluded how the life-time of the battery changes.

Another method for determining the life-time of the battery may use a decrease of a time interval needed for a decrease of the voltage from a voltage threshold to a lower voltage threshold during a discharge cycle of discharging the battery. This method has the drawback that an uncertainty with regard to determining the life-time of the battery is relatively high because the change over time in the battery voltage fall profile during discharing of the battery for standard duration test times, being e.g. 1 hour, 2 hours, or 3 hours, of emergency lighting applications is very small with aging and falls within the battery voltage measurement accuracy tolerance to notice the difference. That is, a temporal change of the battery voltage deacrese during discharging of the battery may be within the accuracy tolerance of measuring the battery voltage and, thus, one cannot be sure whether a measured change is due to an actual change or due to the accuranc tolerance of the battery voltage measurement.

Therefore, it is an object of the invention to provide an entity and method for testing a life-time of a battery being an emergency electrical energy storage of an emergency lighting system. Especially, it may be an object of the invention to provide such entity and method that is improved with regard to the validity of the determined life-time of the battery.

These and other objects, which become apparent upon reading the following description, are solved by the subject-matter of the independent claims. The dependent claims refer to preferred embodiments of the invention.

According to a first aspect of the invention, an entity for testing a life-time of a battery being an emergency electrical energy storage of an emergency lighting system is provided. The entity is configured to perform the following testing steps:
- triggering charging of the battery having a voltage smaller than a first voltage threshold,
- determining a time interval between a first point in time, at which the voltage of the battery exceeds the first voltage threshold, and a second point in time, at which the voltage of the battery reaches a second voltage threshold being greater than the first voltage threshold, and
- determining a remaining battery capacity of the battery using the determined time interval and an initial value of the time interval.

In other words, the first aspect proposes charging of the battery, in case the battery has a voltage that is smaller than the first voltage threshold, and determining, during the charging of the battery, the time interval between the first point in time, when the battery voltage exceeds the first voltage threshold, and the second point in time, when the battery voltage reaches the second voltage threshold. The remaining battery capacity of the battery and, thus, the life-time of the battery may then be determined using the determined time interval and an initial value of the time interval.

Thus, the entity allows testing a life-time of the battery of the emergency lighting system. Especially, since the battery has the voltage smaller than the first voltage threshold before being charged, a change over time of the above mentioned time interval that is determined during the charging of the battery is greater than a battery voltage measurement accuracy tolerance. Therefore, the remaining battery capacity and, thus, the life-time of the battery determined at a current point time using the time interval determined at that current point in time and the initial value of the time interval is accurate and may not be spoiled due to an accuracy measurement tolerance of the battery voltage measurement. Therefore, the entity of the first aspect is improved with regard to the validity of the remaining battery capacity and, thus, the life-time of the battery determined by the entity.

The entity of the first aspect may also be referred to as an entity for testing a remaining battery capacity of a battery being an emergency electrical energy storage of an emergency lighting system.

The entity may be software and/or hardware. For example, the entity may be software that may be used to configure (e.g. program) a control unit of the emergency lighting system. Optionally, the entity may be a testing device for testing the life-time of the battery. For example, the entity may be a user device (portable or stationary), such as a handheld device, a smart phone, a tablet, a laptop computer, a stationary computer etc. Optionally, the entity may be or may be part of a control unit of the emergency lighting system.

The entity may be or may comprise a microcontroller, controller, microprocessor, processor, application specific integrated circuit (ASIC), field programmable gate array (FPGA) or any combination thereof.

The entity may be configured to communicate with the emergency lighting system, especially with the components of the emergency lighting system. This communication may be wireless and/or wired. For example, for triggering charging of the battery the entity may communicate with a control unit and/or a charging unit for charging the battery of the emergency lighting system accordingly, e.g. provide to the control unit and/or charging circuit of the emergency lighting system an instruction instructing the charging. For example, for determining the time interval during the charging of the battery, the entity may be configured to receive a measurement of the battery voltage and/or the first and second point in time from a control unit and/or a measurement circuit for measuring the battery voltage of the emergency lighting system. In case the entity is the control unit of the emergency lighting system the above description is correspondingly valid.

The above description of an emergency lighting system is corresponding valid for the emergency lighting system mention with regard to describing the entity according to the first aspect.

For example, the battery may be a lithium-ion battery. This is only by way of example and the battery may be any other known battery type.

The entity may be configured to determine whether the battery voltage is smaller than the first voltage threshold. For example, for this the entity may be configured to obtain from a measurement circuit of the emergency lighting system measurements of the battery voltage and compare such measurements with the first voltage threshold. In addition or alternatively, the entity may be configured to obtain from the emergency lighting system, e.g. a control unit of the system, the information whether the battery voltage is smaller than the first voltage threshold or not.

The entity may comprise or may be configured to access a data storage, such as a non-volatile data storage, that stores the initial value of the time interval.

The initial value of the time interval may be determined when the emergency lighting system was installed (e.g. the first time) or when the battery was provided as the emergency electrical energy storage to the emergency lighting system. Optionally, the entity may be configured to determine the initial value of the time interval.

Optionally, the testing steps comprise triggering discharging of the battery such that the voltage of the battery decreases below the first voltage threshold, and triggering the charging of the battery after the discharging has ended.

That is, the entity may be configured to perform the following testing steps:
- triggering discharging of the battery such that the voltage of the battery decreases below the first voltage threshold,
- triggering the charging of the battery after the discharging has ended,
- determining a time interval between a first point in time, at which the voltage of the battery exceeds the first voltage threshold, and a second point in time, at which the voltage of the battery reaches a second voltage threshold being greater than the first voltage threshold, and
- determining a remaining battery capacity of the battery using the determined time interval and an initial value of the time interval.

In other words, for testing the life-time of the battery, the battery may be discharged such that during the discharging the battery voltage decreases below the first threshold value. After the discharging has stopped, the battery may be charged again. During the charging of the battery the time interval may be determined and, then, the remaining battery capacity may be determined using the determined time interval and the initial value of the time interval.

Since in the above optional implementation form the discharging results in the voltage of the battery decreasing below the first voltage threshold, the step of triggering the charging of the battery after the discharging has ended corresponds to the step of triggering charging of the battery having a voltage smaller than a first voltage threshold.

The entity may be configured to trigger discharging of the battery such that discharging ends when the voltage of the battery reaches a lower voltage boundary smaller than the first voltage threshold. For this the entity may obtain a measurement of the battery voltage from a measurement circuit of the emergency lighting system for measuring the battery voltage and stop the discharging of the batter (e.g. instruct stopping the discharging) when the battery voltage reaches the lower voltage boundary. Alternatively, the entity may be configured to trigger discharging of the battery for a discharging time, wherein the discharging time ensures that the voltage of the battery decreases below the first voltage threshold during the discharging of the battery.

The entity may be configured to trigger the discharging of the battery for the discharging time by triggering a duration test of the battery. The duration test discharges the battery during the discharging time such that the voltage of the battery decreases below the first voltage threshold. For example, a discharging time of a duration test may be one hour, two hours or three hours.

The entity may trigger the charging of the battery after the discharging has ended such that the voltage of the battery returns to a value present before the discharging of the battery is started. The entity may trigger the charging of the battery (e.g. after discharging has ended) such that the voltage of the battery returns to the second voltage threshold or exceeds the second voltage threshold.

For triggering discharging of the battery the entity may be configured to trigger a duration test of the emergency lighting system. A duration test of the emergency lighting system and a duration test of the battery of the emergency lighting system may be used as synonyms. For triggering discharging of the battery the entity may be configured to instruct the emergency lighting system, e.g. a control unit of the system or an electrical supply unit for electrically supplying a light source in the emergency operation state, to use electrical energy stored by the battery such that the battery is discharged and, thus, the battery voltage decreases below the first voltage threshold.

The entity may be configured to compute a percentage reduction of the battery capacity of the battery with regard to an initial battery capacity of the battery by computing a percentage reduction of the determined time interval compared to the initial value of the time interval. The entity may be configured to determine the remaining battery capacity using the computed percentage reduction of the battery capacity.

This allows easily determining the remaining battery capacity and, thus, the life-time of the battery, as merely the battery voltage is measured during the charging of the battery and the measured battery voltage is compared with the first voltage threshold and the second voltage threshold. No complex mathematical algorithms or statistical evaluation need to be performed for determining the remaining battery capacity.

The entity may be configured to compute the percentage reduction of the determined time interval compared to the initial value of the time interval by subtracting the determined time interval from the initial value of the time interval and dividing the subtraction result by the initial value of the time interval.

Determining the remaining battery capacity may be determining a percentage reduction in the battery capacity compared to an initial value of the battery capacity. The initial value of the battery capacity may be determined when the emergency lighting system was installed (e.g. the first time) or when the battery was provided as the emergency electrical energy storage to the emergency lighting system. For example, the initial value of the battery capacity of the battery may be measured at the battery and/or may be retrieved from a data sheet of the battery.

Optionally, the entity may be configured to compute the percentage reduction in the time interval compared to the initial value of the time interval and directly use the computed percentage reduction as a percentage reduction in the battery capacity of the battery compared to the initial value of the battery capacity. Optionally, the entity may be configured to adjusted the computed percentage reduction in the time interval with an adjustment value, e.g. by multiplying the computed percentage reduction with the adjustment value, to obtain the percentage reduction in the battery capacity compared to the initial value of the battery capacity.

The entity may be configured to compute the remaining battery capacity by multiplying the initial value of the battery capacity with a value that equals one hundred percent minus the percentage reduction in the time interval compared to the initial value of the time interval. Optionally, in the aforementioned case the hundred percent may be subtracted by the percentage reduction in the time interval compared to the initial value of the time interval being adjusted with an adjustment value, e.g. by being multiplied with the adjustment value.

Optionally, the remaining battery capacity may be represented in terms of a percentage of the initial value of the battery capacity. In this case, the entity may be configured to compute the remaining battery capacity by subtracting the percentage reduction in the time interval compared to the initial value of the time interval from one hundred percent. Optionally, in the aforementioned case the hundred percent may be subtracted by the percentage reduction in the time interval compared to the initial value of the time interval being adjusted with an adjustment value, e.g. by being multiplied with the adjustment value. Optionally, the entity may be configured to compute the remaining battery capacity being represented in terms of a percentage of the initial value of the battery capacity by dividing the determined time interval by the initial value of the time interval.

Optionally the entity is configured to output, in response to the determined remaining battery capacity being smaller than a threshold value for the battery capacity, via a communication interface the information that the remaining battery capacity is insufficient for an emergency operation of the emergency lighting system. Optionally, the communication interface is a digital addressable lighting interface (DALI) communication interface. DALI is a known standard in the field of lighting. Herein, the term "DALI "may comprise DALI version 1 and DALI version 2. In addition or alternatively, the entity may be configured to output, in response to the determined remaining battery capacity being smaller than the threshold value for the battery capacity, via indicator lighting means the information that the remaining battery capacity is insufficient for an emergency operation of the emergency lighting system. Optionally, the indicator lighting means are an indicator light emitting diode (LED).

This allows reporting to a user or a control unit, such as a central control unit, that the battery should be replaced in case the determined remaining battery capacity is not sufficient for an emergency operation of the emergency lighting system.

The threshold value for the battery capacity is such that a battery capacity being smaller than the threshold value is not sufficient for providing an electrical energy supply during the emergency operation of the emergency lighting system for a desired time. The desired time is a time for which the emergency lighting system should be able to provide emergency lighting. This may be defined by safety regulations, such as national or international safety regulations

Optionally, the entity is configured to perform the testing steps at regular repeating points in time, and determine a remaining life-time of the battery using an extrapolation function and two or more determined remaining battery capacities of the battery determined at two or more points in time of the regular repeating points in time.

That is, the entity may be configured to store the determined remaining battery capacity at each of the regular repeating points in time. For this, the entity may comprise a data storage or may be configured to access an external data storage. The data storage may be a non-volatile data storage. The regular repeating points in time may be spaced apart by a regular time interval, such as six months or one year. Thus, at a current point in time the entity may determine the remaining life-time of the battery using an extrapolation function and the remaining battery capacity determined at the current point in time and one or more remaining battery capacities of the battery determined at one or more past points in time of the regular repeating points in time.

The entity may be configured to trigger the charging of the battery having the voltage smaller than the first voltage threshold such that the battery is charged in a constant current charging phase.

In other words, the charging of the battery having the voltage smaller than the first voltage threshold may be done by performing a constant current charging phase of the battery. That is, the batters may be charged such that a current of the battery is kept constant while the voltage of the battery increases.

Optionally, the second voltage threshold equals to a voltage at which a constant current charging phase stops and a constant voltage charging phase is started during the charging of the battery.

That is, the second voltage threshold may be a voltage threshold, where the constant current charging phase transits to the constant voltage charging phase during charging of the battery (i.e. transits from constant current to constant voltage charging). During a constant voltage charging phase of charging the battery the voltage of the battery may be kept constant, while the current of the battery may decrease, e.g. exponential decrease.

Optionally, the entity is configured to perform the testing steps every six months and/or every year.

Optionally, the entity may be configured to perform a duration test every six months and/or year and trigger charging of the battery and determine the time interval each time after the duration test has ended.

Optionally, the entity may be configured to, in response to an event, perform the following second type testing steps:
- triggering charging of the battery for a maximum charging time,
- triggering, after the battery has been charged for the maximum charging time, discharging of the battery such that the voltage of the battery decreases below the first voltage threshold,
- triggering charging the battery after the discharging has ended,
- determining the time interval, and
- storing the determined time interval as the initial value of the time interval.

In other words, in response to the event, the battery may be charged for the maximum charging time, and after that the battery may be discharged such that the battery voltage decreased below the first voltage threshold. After the discharging of the battery has stopped, the battery may be charged again and the time interval may be determined during the charging of the battery. The determined time interval may be stored as the initial value of the time interval.

Triggering charging of the battery for a maximum charging time may mean that a full charging of the battery is performed to ensure that the battery is fully charged. The maximum charging time may be for example 20 hours.

The entity may be configured to trigger, after the battery has been charged for the maximum charging time, discharging of the battery such that discharging ends when the voltage of the battery reaches a lower voltage boundary smaller than the first voltage threshold. Alternatively, the entity may be configured to trigger, after the battery has been charged for the maximum charging time, discharging for a discharging time, wherein the discharging time ensures that the voltage of the battery decreases below the first voltage threshold during the discharging of the battery.

The entity may be configured to trigger the discharging of the battery for the discharging time by triggering a duration test of the battery. The duration test discharges the battery during the discharging time such that the voltage of the battery decreases below the first voltage threshold.

The event may be one of
- an installation of the emergency lighting system (e.g. the first time),
- the battery is removed from the emergency lighting system while mains supply of the emergency lighting system is present and the removed battery or a new battery is provided as the emergency electrical energy storage of the emergency lighting system,
- the battery or a new battery is provided as the emergency electrical energy storage of the emergency lighting system after the emergency lighting system is powered on while no battery is present as the emergency electrical energy storage of the emergency lighting system and mains supply of the emergency lighting system is present,
- the battery or a new battery is provided as the emergency electrical energy storage to the emergency lighting system after the battery has been removed in an emergency operation state of the emergency lighting system and mains supply of the emergency lighting system has recovered, and
- the battery or a new battery is provided as the emergency electrical energy storage to the emergency lighting system after the battery has been discharged down to a quiescent voltage battery cut off in the emergency operation state of the emergency lighting system and mains supply of the emergency lighting system has recovered.

The entity may be configured to determine an installation of the emergency lighting system (e.g. the first time) by obtaining the information from outside, e.g. by an input of a user installing the emergency lighting system. In addition or alternatively, the entity may configured to determine an installation of the emergency lighting system (e.g. the first time) by obtaining the information from the emergency lighting system, which is configured to provide this information, when it is operated for the first time or in a setup mode.

The entity may be configured to obtain information on whether the emergency lighting system is in the emergency operation state or in the normal operation state.

The entity may be configured to determine that the battery is removed from the emergency lighting system while mains supply of the emergency lighting system is present and the removed battery or a new battery is provided as the emergency electrical energy storage of the emergency lighting system by obtaining the information from outside, e.g. by an input of a user removing the battery. The entity may be configured to obtain a measurement of mains supply of the emergency lighting system and, thus, may determine whether the electrical supply from mains is disturbed or not, i.e. whether mains is present or not. For this, the entity may be configured to compare a voltage received from mains supply with an emergency state voltage threshold. The entity may be configured to determine that the electrically supply from mains is disturbed, when it determines that the voltage received from mains supply is smaller than the emergency state voltage threshold. The entity may be configured to determine that the electrically supply from mains works properly, when it determines that the voltage received from mains supply is greater than the emergency state voltage threshold (e.g. by a safety extent).

Optionally, the entity may be configured to determine that the battery is removed from the emergency lighting system by obtaining a measurement of the battery voltage from a measurement circuit of the emergency lighting system. The entity may determine that the battery is removed when the measurement of the battery voltage falls below a dedicated voltage threshold, e.g. falls to zero Volts, i.e. when no battery voltage is measured. The entity may determine that the battery or a new battery is provided when the measurement of the battery voltage raises to a value greater than zero Volts, i.e. when a battery voltage is measured.

The entity may be configured to determine that the battery or a new battery is provided as the emergency electrical energy storage of the emergency lighting system after the emergency lighting system is powered on while no battery is present as the emergency electrical energy storage of the emergency lighting system and mains supply of the emergency lighting system is present by obtaining the information from outside, e.g. by an input of a user providing the battery. Optionally, the entity may be configured to determine that the battery or a new battery is provided as the emergency electrical energy storage of the emergency lighting system by obtaining a measurement of the battery voltage from a measurement circuit of the emergency lighting system. The entity may determine that the battery or a new battery is provided when the measurement of the battery voltage raises to a value greater than zero Volts, i.e. when a battery voltage is measured. The entity may know whether a mains supply is present or not as outlined above.

The entity may be configured to determine that the battery or a new battery is provided as the emergency electrical energy storage to the emergency lighting system after the battery has been removed in an emergency operation state of the emergency lighting system and mains supply of the emergency lighting system has recovered by obtaining the information from outside, e.g. by an input of a user providing the battery. Optionally, the entity may be configured to determine that the battery or a new battery is provided as the emergency electrical energy storage to the emergency lighting system by obtaining a measurement of the battery voltage from a measurement circuit of the emergency lighting system. The entity may determine that the battery or a new battery is provided when the measurement of the battery voltage raises to a value greater than zero Volts, i.e. when a battery voltage is measured. The entity may know whether a mains supply is present or not as outlined above.

The entity may be configured to determine that the battery or a new battery is provided as the emergency electrical energy storage to the emergency lighting system after the battery has been discharged down to a quiescent voltage battery cut off in the emergency operation state of the emergency lighting system and mains supply of the emergency lighting system has recovered by obtaining the information from outside, e.g. by an input of a user providing the battery. The entity may be configured to obtain a measurement of the battery voltage from a measurement circuit of the emergency lighting system and to determine that the battery has been discharged down to the quiescent voltage batter cut off using the measurement of the battery voltage (e.g. comparing the measurement of the battery voltage with a respective voltage threshold for the quiescent voltage battery cut off). Optionally, the entity may be configured to determine that the battery or a new battery is provided as the emergency electrical energy storage to the emergency lighting system by obtaining a measurement of the battery voltage from a measurement circuit of the emergency lighting system. The entity may determine that the battery or a new battery is provided when the measurement of the battery voltage raises to a value greater than zero Volts, i.e. when a battery voltage is measured. The entity may know whether a mains supply is present or not as outlined above.

Optionally, the entity is configured to compare the determined time interval with the initial value of the time interval, and store the determined time interval as the initial value of the time interval in case the determined time interval is greater than or equal to the initial value of the time interval.

In order to achieve the entity according to the first aspect of the invention, some or all of the above described optional features may be combined with each other.

According to a second aspect of the invention, an emergency lighting system is provided. The emergency lighting system comprises a battery as an emergency electrical energy storage, and an electrical supply circuit for electrically supplying a light source from one of the battery and a connector for being electrically connected with mains. The emergency lighting system comprises an entity according to the first aspect of the invention, as described above. The entity is configured to test the life-time of the battery.

The description of the entity according to the first aspect is correspondingly valid for the emergency lighting system according to the second aspect. The description of the emergency lighting system according to the second aspect is correspondingly valid for the entity according to the first aspect. The above description of the emergency lighting system is correspondingly valid for the emergency lighting system of the second aspect.

The entity may be or may comprise a microcontroller, controller, microprocessor, processor, application specific integrated circuit (ASIC), field programmable gate array (FPGA) or any combination thereof.

The entity may be a battery life-time testing unit that is configured to communicate (wired and/or wirelessly) with other components of the emergency lighting system. For example, such components may be a measurement circuit for measuring voltage and optionally current of the battery, the electrical supply circuit, a control unit of the emergency lighting system, a charging circuit for charging the battery etc. In this regard, communication may comprise providing instructions to a respective component, such as triggering charging of the battery by providing a respective instruction to the control unit of the emergency lighting system or directly to the charging circuit, or obtaining measurements results, such as the voltage of the battery.

Alternatively, the entity may be part or may be a control unit of the emergency lighting system. The control unit of the emergency lighting system is configured to control the components and receive information from the components of the emergency lighting system.

The light source may comprise one or more light emitting diodes (LEDs). In addition or alternatively, the light source may comprise one or more other types of lighting means known in the art.

The emergency lighting system may be an emergency luminaire comprising the light source electrically connected to the electrical supply circuit. Alternatively, the emergency lighting system may be an emergency lighting driver configured to be electrically connected to the light source.

The emergency lighting system may be an emergency luminaire comprising one or more LEDs as the light source. That is, the emergency lighting system may be an emergency LED luminaire. The emergency lighting system may be an emergency LED driver configured to be electrically connected to the light source comprising one or more LEDs.

The emergency lighting system may comprise a data storage, such as a non-volatile data storage, and the entity may be configured to store in the data storage the initial value of the time interval. The entity may be configured to access, e.g. read from and write to, the data storage. The data storage may be a part of the entity.

Optionally, the emergency lighting system comprises a communication interface, and the entity may be configured to provide information to outside the emergency lighting system via the communication interface. For example, the communication interface may be a DALI communication interface. In addition or alternatively, the emergency lighting system may comprise indicator lighting means, and the entity may be configured to provide information to outside the emergency lighting system via the indicator lighting means. For example, the indicator lighting means may be an indicator LED.

The emergency lighting system according to the second aspect of the invention achieves the same advantages as the entity according to the first aspect of the invention.

In order to achieve the emergency lighting system according to the second aspect of the invention, some or all of the above described optional features may be combined with each other.

According to a third aspect of the invention, a method for testing a life-time of a battery being an emergency electrical energy storage of an emergency lighting system is provided. The method comprises the steps of
- charging the battery having a voltage smaller than a first voltage threshold,
- determining a time interval between a first point in time, at which the voltage of the battery exceeds the first voltage threshold, and a second point time, at which the voltage of the battery reaches a second voltage threshold being greater than the first voltage threshold, and
- determining a remaining battery capacity of the battery using the determined time interval and an initial value of the time interval.

The description of the entity according to the first aspect is correspondingly valid for the method according to the third aspect. That is, processes triggered by the entity according to the first aspect, such as charging or discharging of the battery, or steps performable by the entity according to the first aspect may be method steps of the method according to the third aspect of the invention.

The method of the third aspect may also be referred to as a method for testing a remaining battery capacity of a battery being an emergency electrical energy storage of an emergency lighting system.

The method according to the thirds aspect of the invention achieves the same advantages as the entity according to the first aspect of the invention.

In order to achieve the method according to the third aspect of the invention, some or all of the above described optional features may be combined with each other.

In the following, the invention is described exemplarily with reference to the enclosed figures (FIGs.), in which
- **FIG. 1**: shows an example of an entity according to an embodiment of the invention for testing a life-time of a battery being an emergency electrical energy storage of an emergency lighting system;
- **FIG. 2**: shows an example of an emergency lighting system according to an embodiment of the invention;
- **FIG. 3**: shows an example of an implementation form of the emergency lighting system of FIG. 2;
- **FIG. 4**: shows a graph showing an example of a voltage and current of a battery during a charging procedure of the battery according to an embodiment of the invention;
- **FIG. 5**: shows a graph showing an example of a voltage of a battery during several charging procedures of the battery according to an embodiment of the invention;
- **FIG. 6**: shows a table showing an example of a relationship between a percentage reduction in a time interval that may be determined by the entity of FIG. 1 during charging of a battery and a percentage reduction in a battery capacity of the battery for several life-testing processes at two different temperatures;
- **FIG. 7**: shows a graph showing the data of the table of FIG. 6;
- **FIG. 8**: shows a table showing an example of a relationship between a percentage reduction in a time interval that may be determined by the entity of FIG. 1 during charging of a battery and a percentage reduction in a battery capacity of the battery for several life-testing processes at two different temperatures;
- **FIG. 9**: shows a graph showing the data of the table of FIG. 8;
- **FIG. 10**: shows an example of a method according to an embodiment of the invention for testing a life-time of a battery being an emergency electrical energy storage of an emergency lighting system;
- **FIG. 11**: shows an example of a method according to an embodiment of the invention for testing a life-time of a battery being an emergency electrical energy storage of an emergency lighting system; and
- **FIGs. 12 (a), 12 (b) and 12 (c)**: show an example of a method according to an embodiment of the invention for testing a life-time of a battery being an emergency electrical energy storage of an emergency lighting system.

In the figures (FIGs.), corresponding elements have the same reference signs, and may be implemented likewise.

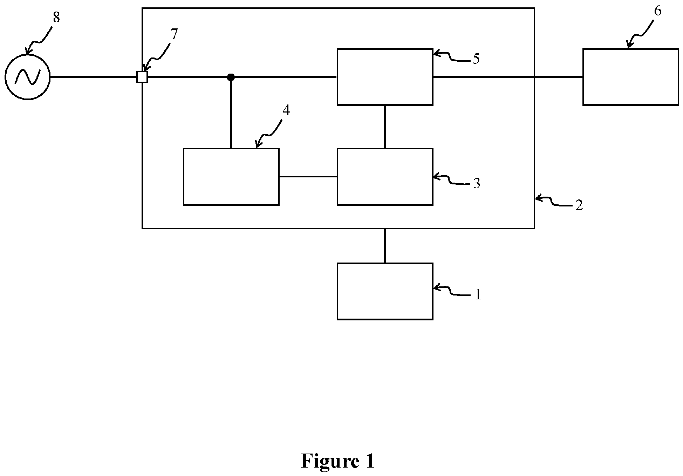

**FIG. 1** shows an example of an entity according to an embodiment of the invention for testing a life-time of a battery being an emergency electrical energy storage of an emergency lighting system. The entity of FIG. 1 is an example of the entity according to the first aspect of the invention. The description of the entity according to the first aspect is correspondingly valid for the entity of FIG. 1.

The entity 1 of FIG. 1 is an entity for testing a life-time of a battery 3 being an emergency electrical energy storage of an emergency lighting system 2. The entity 1 is configured to perform the following testing steps: triggering charging of the battery 3 having a voltage smaller than a first voltage threshold, determining a time interval between a first point in time, at which the voltage of the battery 3 exceeds the first voltage threshold, and a second point in time, at which the voltage of the battery 3 reaches a second voltage threshold being greater than the first voltage threshold, and determining a remaining battery capacity of the battery 3 using the determined time interval and an initial value of the time interval.

The entity 1 may be a testing device for testing the life-time of the battery 3. For example, the entity 1 may be a user device (portable or stationary), such as a handheld device, a smart phone, a tablet, a laptop computer, a stationary computer etc.

As shown in FIG. 1, the emergency lighting system 2 comprises the battery 3 as an emergency electrical energy storage, and an electrical supply circuit 5 for electrically supplying a light source 6 from one of the battery 3 and a connector 7 for being electrically connected with mains 8. The emergency lighting system 2 may comprise a battery charging circuit 4 for charging the battery 3 with electrical energy from mains 8. For example, the battery 3 may be a lithium-ion battery. This is only by way of example and the battery 3 may be any other known battery type.

For performing the life-time test of the battery 3, the entity 1 may be configured to communicate (wirelessly and/or wired) with the emergency lighting system 2, especial a control unit of the emergency lighting system 2. The entity 1 may be electrically connected with the emergency lighting system 2, e.g. the control unit of the emergency lighting system. The entity 1 may be self-powered (e.g. via a battery, such as a rechargeable battery) and/or may be electrically supplied from the emergency lighting system (e.g. from the battery 3), for example when electrically connected with the emergency lighting system 2.

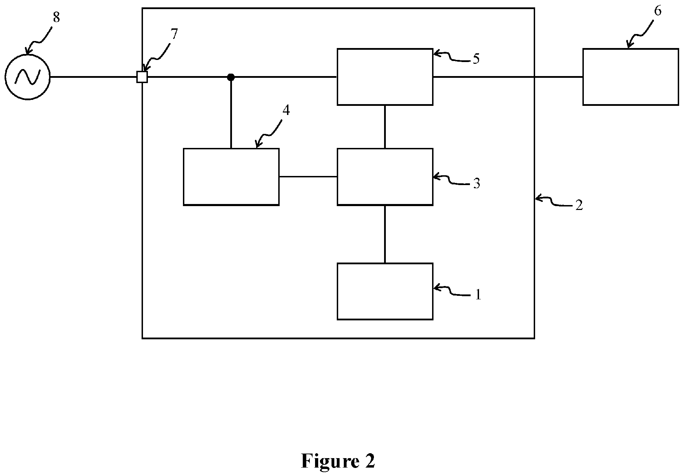

Optionally, the entity 1 may be a part of the emergency lighting system 2 (not shown in FIG. 1, but shown in FIG. 2). In this case, the entity 1 may be a battery life-time testing unit that is configured to communicate (wired and/or wirelessly) with other components of the emergency lighting system 2. For example, such components may be a measurement circuit for measuring voltage and optionally current of the battery 3 (not shown in FIG. 1), the electrical supply circuit 5, the control unit of the emergency lighting system 2 (not shown in FIG. 1), the charging circuit 4 etc. In this regard, communication may comprise providing instructions to a respective component, such as triggering charging of the battery by providing a respective instruction to the control unit of the emergency lighting system 2 or directly to the charging circuit, or obtaining measurements results, such as the voltage of the battery 3.

Alternatively, the entity 1 may be or may be part of a control unit of the emergency lighting system 2 (not shown in FIG. 1). The control unit of the emergency lighting system 2 is configured to control the components and receive information from the components of the emergency lighting system 2. For example, the control unit may be configured to control charging of the battery 3 by instructing the charging circuit 4 accordingly and control discharging of the battery 3 by instructing the electrical supply circuit 5 accordingly. For example, the control unit may be configured to receive measurements of the voltage and optional current of the battery 3, measurements of the voltage and/or current provided by the electrical supply circuit 5 to the light source 6, measurements of voltage and/or current received at the connector 7 from mains 8. Thus, the control unit of the emergency lighting system 2 may determine an emergency operation state when the voltage received at the connector 7 from mains 8 falls below an emergency state voltage threshold. In the emergency operation state, the control unit may control the emergency lighting system 2 such that the electrical supply circuit 5 supplies electrical energy to the light source 6 using electrical energy from the battery 3. In case the voltage received at the connector 7 from mains 8 is greater than the emergency state voltage threshold, e.g. by a safety extent, the control unit may determine a normal operation state. In the normal operation state, the control unit may control the emergency lighting system 2 such that the electrical supply circuit 5 supplies electrical energy to the light source 6 using electrical energy provided at the connector 7 from mains 8. This may be the case when the emergency lighting system is also used for normal lighting operation.

Otherwise, when the emergency lighting system is only used for emergency lighting (i.e. lighting in case of an electrical energy supply from mains 8 is disturbed), the control unit may control in the normal operation state the electrical supply circuit 5 to not provide electrical energy to the light source. In the normal operation state the control unit may control the charging circuit 4 to charge the battery 3 using electrical energy provided at the connector 7 from mains 8.

The light source 6 may comprise one or more light emitting diodes (LEDs). In addition or alternatively, the light source may comprise one or more other types of lighting means known in the art.

The emergency lighting system 2 may be an emergency luminaire comprising the light source 6 (not shown in FIG. 1) that is electrically connected to the electrical supply circuit 5. Alternatively, the emergency lighting system 2 may be an emergency lighting driver configured to be electrically connected to the light source.

For further details of the entity 1 of FIG. 1 reference is made to the above description of the entity according to the first aspect of the invention and the description of the following FIGs.

**FIG. 2** shows an example of an emergency lighting system according to an embodiment of the invention. The emergency lighting system of FIG. 2 corresponds to the emergency lighting system of FIG. 1 with an additional feature. Further, the emergency lighting system of FIG. 2 is an example of the emergency lighting system according to the second aspect of the invention. Therefore, for describing the emergency lighting system of FIG. 2 reference is made to the description of FIG. 1 and in the following mainly the additional feature of the emergency lighting system of FIG. 2 is described. The description of the emergency lighting system according to the second aspect of the invention is correspondingly valid for the emergency lighting system of FIG. 2.

As shown in FIG. 2, the emergency lighting system comprises the entity 1 of FIG. 1. The entity 1 is configured to test the life-time of the battery 3. In FIG. 2, electrical supply paths between the components of the emergency lighting system are shown. Thus, as shown in FIG. 2, the connector 7 of the emergency lighting system may be electrically connected to mains 8 so that the emergency lighting system 2 may be electrically supplied from mains 8. The charging circuit 4 and the electrical supply circuit 5 may be electrically connected to the connector 7 in order to be configured to obtain electrical energy provided at the connector 7 from mains 8. The electrical supply circuit 5 may be electrically connected to the light source 6 in order to be configured to provide electrical energy to the light source 6. The battery 3 may be electrically connected to the charging circuit 4 and the electrical supply circuit 5 in order to be configured to be charged by the charging circuit 4 and to provide electrical energy to the electrical supply circuit 5 e.g. in the emergency operation state. The entity 1 may be electrically connected to the battery 3 in order to be electrical powered with electrical energy from the battery 3.

For further information on the emergency lighting system reference is made to the description of the emergency lighting system according to the second aspect and the description of FIG. 1.

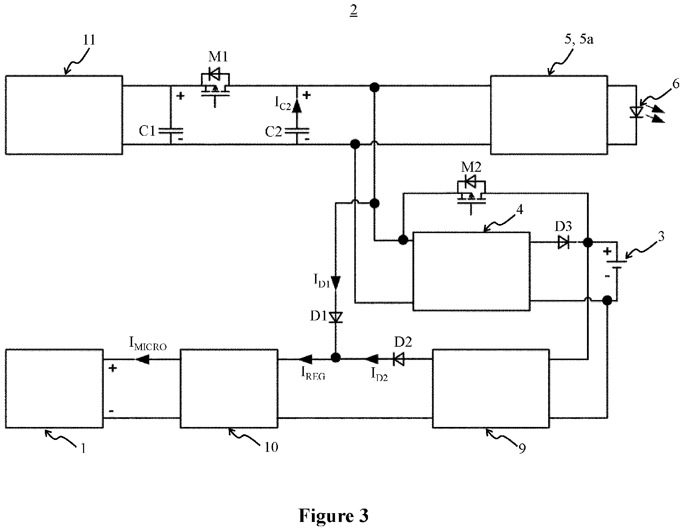

**FIG. 3** shows an example of an implementation form of the emergency lighting system according to FIG. 2. The description of FIGs. 1 and 2 is correspondingly valid for the emergency lighting system of FIG. 3 and, thus, in the following mainly the additional optional features of the emergency lighting system of FIG. 3 are described.

As shown in FIG. 3, the emergency lighting system 2 may comprise a power factor correction (PFC) circuit 11 for receiving electrical energy via the connector 7 (not shown in FIG. 3) from mains 8 (not shown in FIG. 3). The electrical supply circuit 5 may comprise or be a driver circuit 5a (e.g. a LED driver circuit) for driving the light source 6. The driver circuit 5 may comprise at least one electrical power converter, such as at least one actively switched power converter. For providing an electrical energy supply to the entity 1 from the battery 3 the emergency lighting system 2 may comprise a low voltage power supply (LVPS) circuit 9, such as a LVPS boost circuit, and optionally a linear regulator 10. In the example of FIG. 3, the entity 1 is assumed to be the control unit of the emergency lighting system 2. The entity 1 may be for example a microcontroller. The entity 1 is not limited thereto. The entity 1 may be or may comprise a microcontroller, controller, microprocessor, processor, application specific integrated circuit (ASIC), field programmable gate array (FPGA) or any combination thereof. In case the battery 3 is discharged down to a quiescent voltage battery cut off (QVBCO) an electrical supply of the entity 1 is stopped, as the entity 1 is electrically supplied from the battery 3.

As shown in FIG. 3, the emergency lighting system 2 may comprise two switches M1 and M2 in the form of two transistors. The transistor type shown in FIG. 3 is only by way of example. That is the switches M1 and M2 may be implemented by any transistor type known in the art. The switch M1 allows interrupting a power supply from mains 8 when mains 8 is electrical connected via the connector 7 to the emergency lighting system 2, e.g. to the PFC circuit 11. This may be done, for example, in case an emergency situation is to be simulated, such as during a test of the battery 3 (e.g. duration test or function test). The switch M2 allows interrupting a power supply of the electrical supply circuit 5 from the battery 3. This may be done, for example, during a normal operation state when the battery 3 is charged in order to prevent a discharging of the battery 3 by operation of the electrical supply circuit 5. In addition, the emergency lighting system may optionally comprise capacitors C1, C2 and diodes D1, D2 and D3 in order to improve operation of the emergency lighting system, such as stability of the operation. The emergency lighting system 2 may be implemented by any one of the optional features of FIG. 3 or any combination of the optional features of FIG. 3.

The emergency lighting system according to the present invention is not limited to the implementation form of FIG. 3 and, thus, may be differently implemented.

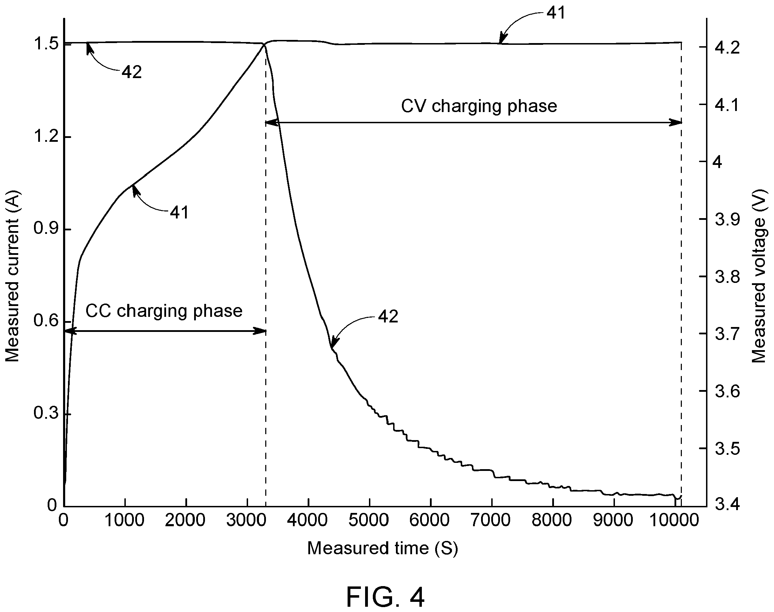

**FIG. 4** shows a graph showing an example of a voltage and current of a battery during a charging procedure of the battery according to an embodiment of the invention. The entity of FIG. 1 may be configured to trigger charging of the battery of the emergency lighting system such that charging takes place according to the charging procedure shown in FIG. 4.

The horizontal axis of the graph of FIG. 4 shows time in seconds (s). The left vertical axis of the graph of FIG. 4 shows a current of the battery in Amperes (A). The right vertical axis of the graph of FIG. 4 shows a voltage of the battery in Volts (V).

The curve 41 of the graph of FIG. 4 shows a change of the voltage of the battery over time. The curve 42 of the graph of FIG. 4 shows a change of the current of the battery over time. As shown in FIG. 4, the battery may be charged such that during a first charging phase the current of the battery is constant and the voltage of the battery increases. This first phase is called constant current charging phase (CC charging phase). Then, for a second charging phase following the first charging phase, the current of the battery decreases while the voltage of the battery is constant during the charging of the battery. As shown in FIG. 4, the current decrease may be an exponential decrease. This second phase is called constant voltage charging phase (CV charging phase).

The entity of FIG. 1 may use the voltage increase during the CC charging phase for determining the time interval between the first point in time, at which the battery voltage exceeds the first voltage threshold, and the second point in time, at which the battery reaches the second voltage threshold, and use the time interval for determining the battery capacity. For this, it is sufficient that the voltage of the battery is smaller than the first voltage threshold before the entity of FIG. 1 triggers the charging of the battery.

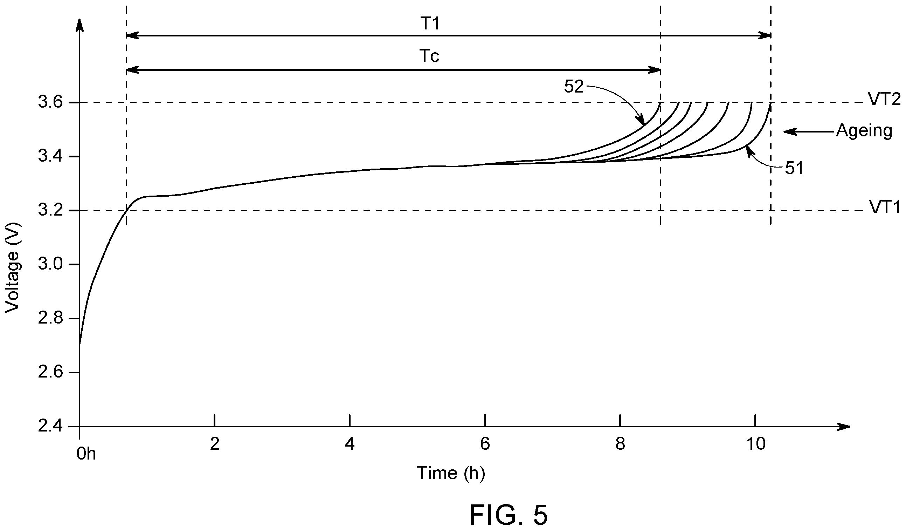

**FIG. 5** shows a graph showing an example of a voltage of a battery during several charging procedures of the battery according to an embodiment of the invention. Especially, FIG. 5 shows an example of an initial value T1 of the time interval that may be determined by the entity 1 of FIG. 1 during charging of the battery having a voltage smaller than the first voltage threshold VT1 before the charging is triggered by the entity 1. FIG. 5 further shows a current value Tc of the aforementioned time interval at a current point in time assuming that the current point in time is 40 weeks later after an initial point in time when the initial value T1 of the time interval has been determined. Thus, between these two points in time 40 weeks of aging of the battery may have taken place, wherein this aging reduces the capacity of the battery.

The horizontal axis of the graph of FIG. 5 shows time in hours and the vertical axis of the graph of FIG. 5 shows a voltage of the battery being charged in Volts (V). The curve 51 shows an initial charging of the battery at the initial point in time, with regard to which aging, i.e. a battery capacity reduction, is to be determined. At this initial point in time, the value of the battery capacity is the initial value of the battery capacity with regard to which a reduction of the battery capacity is to be determined. The curve 52 shows a charging of the battery at the current point in time, at which a percentage reduction in the battery capacity with regard to the initial value of the battery capacity is determined. The current point in time is assumed to be 40 weeks after the initial point in time. That is, 40 weeks of battery aging has taken place between these two points in time.

As may be derived from the graph of FIG. 5, during the charging of the battery the voltage of the battery increases. The graph of FIG. 5 shows the constant current charging phase of charging the battery. In the graph of FIG. 5 the first voltage threshold VT1 and the second voltage threshold VT2 are indicated. In the example of FIG. 5, it is assumed that the first voltage threshold VT1 is e.g. 3.2V and the second voltage threshold VT2 is e.g. 3.6V. This is only by way of example and may be different. As shown in FIG. 5, for all charging procedures, the battery has a voltage smaller than the first voltage thresholds VT1 before the charging is started.

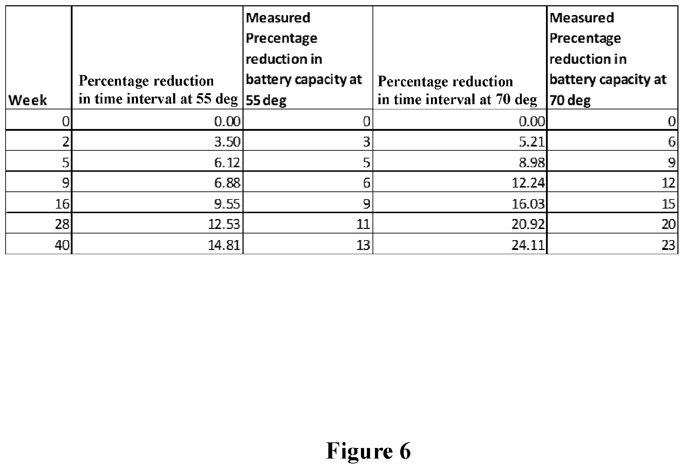

In FIG. 5 the time interval T1 determined at the initial point in time and the time interval Tc determined at the current point in time are shown. That is, each time interval is the time between a first point in time at which the voltage of the battery exceeds the first threshold voltage VT1 and a second point in time at which the voltage of the battery exceeds the second voltage threshold VT2. As may be derived from the graph of FIG. 5, due to aging and, thus, a battery capacity reduction over time, the second point in time, at which the battery voltage reaches the second voltage threshold VT2, is earlier at the current point in time (cf. curve 52) compared to the initial point in time (cf. curve 51). Thus, the time interval Tc determined at the current point in time is shorter or smaller than the time interval T1 determined at the initial point in time. As shown in FIGs. 6 to 9, the percentage reduction in the time interval with regard to the initial value T1 of the time interval may be used to determined (e.g. compute) a percentage reduction in the battery capacity.

**FIG. 6** shows a table showing an example of a relationship between a percentage reduction in a time interval that may be determined by the entity of FIG. 1 during charging of a battery and a percentage reduction in a battery capacity of the battery for several life-testing processes at two different temperatures.

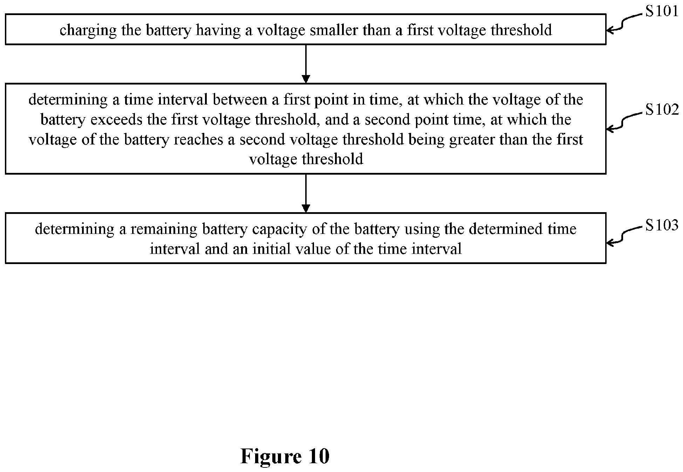

In the table of FIG. 6, the term "time interval" refers to the time interval between the first point in time, at which the voltage of the battery exceeds the first voltage threshold, and the second point in time, at which the voltage of the battery reaches the second voltage threshold that may be determined by the entity of FIG. 1. As shown in FIG. 6, the two different temperatures are 55°C and 70°C. The measurements of the time interval and the battery capacity of the battery where done at an initial point in time equaling to week 0, wherein the time interval and battery capacity measured at this initial point in time are the initial value of the time interval and the battery capacity, respectively. Then the measurements of the time interval and the battery capacity where done at a point in time after 2 weeks, 5 weeks, 9 weeks, 16 weeks, 28 weeks and 40 weeks after the initial point in time. For the measurement of the time interval at a respective point in time the following steps were performed: charging the battery having a voltage smaller than a first voltage threshold and determining the time interval during the charging of the battery. These steps correspond to steps S101 and S102 of the method of FIG. 10. The battery capacity was measured directly at the battery.

As shown in the table of FIG. 6, due to aging of the battery the battery capacity of the battery decreased over time. That is, at each point in time of measuring the battery capacity after the initial point in time the percentage reduction in the battery capacity increased. This is true for both temperatures, 55°C and 70°C. As may be derived from the table of FIG. 6, at each point in time of measuring the time interval after the initial point in time the time interval decreased over time. That is, at each point in time of measuring the time interval after the initial point in time the percentage reduction in the time interval increased. As may be derived from the table of FIG. 6 the increase in percentage reduction in the time interval and the increase in percentage reduction in the battery capacity is direct proportional. This is a proof for the fact that the percentage reduction in the time interval may be used to determine (e.g. compute) the percentage reduction in the battery capacity.

Furthermore, the data of the table of FIG. 6 show that the relationship between the change in the time interval over time and change in the battery capacity over time is independent from a temperature at the battery.

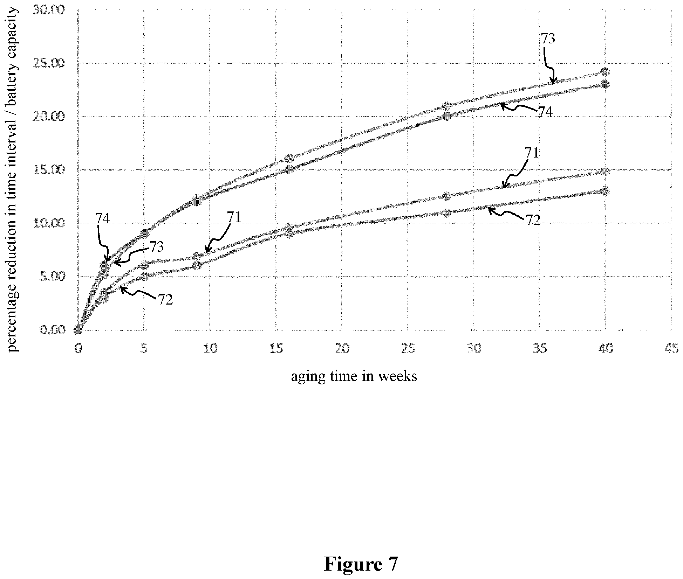

**FIG. 7** shows a graph showing the data of the table of FIG. 6. The description of FIG. 6 is also valid for FIG. 7. The horizontal axis of the graph of FIG. 7 shows time in the amount of weeks passed since an initial point in time (week 0), at which the initial value of the time interval and the battery capacity were determined. Thus, the horizontal axis shows the aging time of the battery in weeks. The vertical axis of the graph of FIG. 7 shows the percentage reduction in the time interval and battery capacity. Thus, at the initial point in time (week 0) the percentage reduction in the time interval and the battery capacity is zero.

The curve 71 shows the measured percentage reduction in the time interval when a temperature of 55°C is present at the battery. The curve 72 shows the measured percentage reduction in the battery capacity when a temperature of 55°C is present at the battery. The curve 73 shows the measured percentage reduction in the time interval when a temperature of 70°C is present at the battery. The curve 74 shows the measured percentage reduction in the battery capacity when a temperature of 70°C is present at the battery.

As may be derived from the graph of FIG. 7, the curves 71 and 72 have the same temporal change. That is, for the temperature of 55°C the curve 71 of the percentage reduction in the time interval shows the same temporal change as the curve 72 of the percentage reduction in the battery capacity. Thus, the percentage reduction in the time interval may be used to determine the percentage reduction in the battery capacity. The same is true for the measurements taken at a temperature of 70°C. Namely, as may be derived from the graph of FIG. 7, the curves 73 and 74 have the same temporal change. That is, for the temperature 70°C the curve 73 of the percentage reduction in the time interval shows the same temporal change as the curve 74 of the percentage reduction in the battery capacity. Therefore, FIG. 7 also shows that the relationship between the increase of the percentage reduction in the time interval over time and the increase of the percentage reduction in the battery capacity over time is independent from the temperature at the battery.

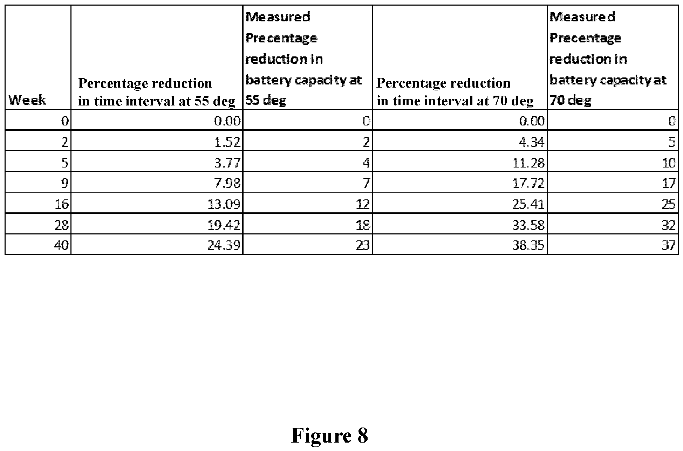

**FIG. 8** shows a table showing an example of a relationship between a percentage reduction in a time interval that may be determined by the entity of FIG. 1 during charging of a battery and a percentage reduction in a battery capacity of the battery for several life-testing processes at two different temperatures. The difference between the data of FIG. 8 and FIG. 6 is that different types of batteries where used for the measurements. The description of FIG. 6 is correspondingly valid for the table of FIG. 8.

The table of FIG. 8 basically shows the same relationship between the percentage reduction in the time interval and the percentage reduction in the battery capacity as the table of FIG. 6. Therefore, as may be derived from the tables of FIGs. 6 and 8, the relationship between the percentage reduction in the time interval and the percentage reduction in the battery capacity is independent from the specific type of battery used. Moreover, the relationship between the percentage reduction in the time interval and the percentage reduction in the battery capacity is independent from the battery company or battery provider.

Moreover, the table of FIG. 8 also shows that the relationship between the percentage reduction in the time interval and the percentage reduction in the battery capacity is independent from the temperature at the battery. Namely, the table of FIG. 8 shows for the temperature of 55°C and 70°C that over time both the percentage reduction in the time interval and the percentage reduction in the battery capacity increases. Thus, independent from the temperature at the battery and independent from the battery type, the percentage reduction in the time interval over time may be used to determine the percentage reduction of the battery capacity over time.

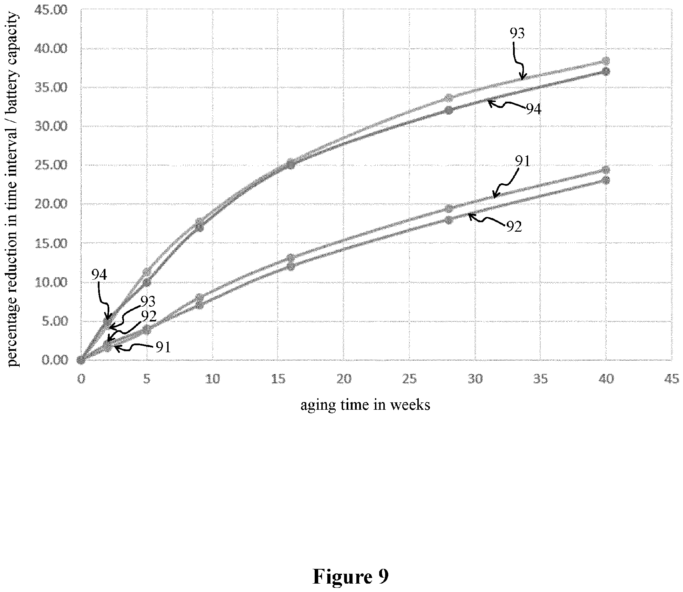

**FIG. 9** shows a graph showing the data of the table of FIG. 8. The horizontal axis of the graph of FIG. 9 shows time in the amount of weeks passed since an initial point in time (week 0), at which the initial value of the time interval and the battery capacity were determined. Thus, the horizontal axis shows the aging time of the battery in weeks. The vertical axis of the graph of FIG. 9 shows the percentage reduction in the time interval and battery capacity. Thus, at the initial point in time (week 0) the percentage reduction in the time interval and the battery capacity is zero.

The curve 91 shows the measured percentage reduction in the time interval when a temperature of 55°C is present at the battery. The curve 92 shows the measured percentage reduction in the battery capacity when a temperature of 55°C is present at the battery. The curve 93 shows the measured percentage reduction in the time interval when a temperature of 70°C is present at the battery. The curve 94 shows the measured percentage reduction in the battery capacity when a temperature of 70°C is present at the battery.

As may be derived from the graph of FIG. 9, the curves 91 and 92 have the same temporal change. That is, for the temperature of 55°C the curve 91 of the percentage reduction in the time interval shows the same temporal change as the curve 92 of the percentage reduction in the battery capacity. Thus, the percentage reduction in the time interval may be used to determine the percentage reduction in the battery capacity. The same is true for the measurements taken at a temperature of 70°C. Namely, as may be derived from the graph of FIG. 9, the curves 93 and 94 have the same temporal change. That is, for the temperature 70°C the curve 93 of the percentage reduction in the time interval shows the same temporal change as the curve 94 of the percentage reduction in the battery capacity. Therefore, FIG. 9 also shows that the relationship between the increase of the percentage reduction in the time interval over time and the increase of the percentage reduction in the battery capacity over time is independent from the temperature at the battery.

**FIG. 10** shows an example of a method according to an embodiment of the invention for testing a life-time of a battery being an emergency electrical energy storage of an emergency lighting system. The method of FIG. 10 is an example of the method according to the third aspect of the invention. The description of the method according to the third aspect is correspondingly valid for the method of FIG. 10.

As shown in FIG. 10, the method comprises a step S101 of charging the battery having a voltage smaller than a first voltage threshold. The method comprises a step S102 of determining, during the charging of the battery, a time interval between a first point in time, at which the voltage of the battery exceeds the first voltage threshold, and a second point time, at which the voltage of the battery reaches a second voltage threshold being greater than the first voltage threshold. The method comprises after the step S102 a step S103 of determining a remaining battery capacity of the battery using the determined time interval and an initial value of the time interval.

For further information on the method of FIG. 10 reference is made to the description of the entity of the first aspect, and the description of the method of the third aspect.

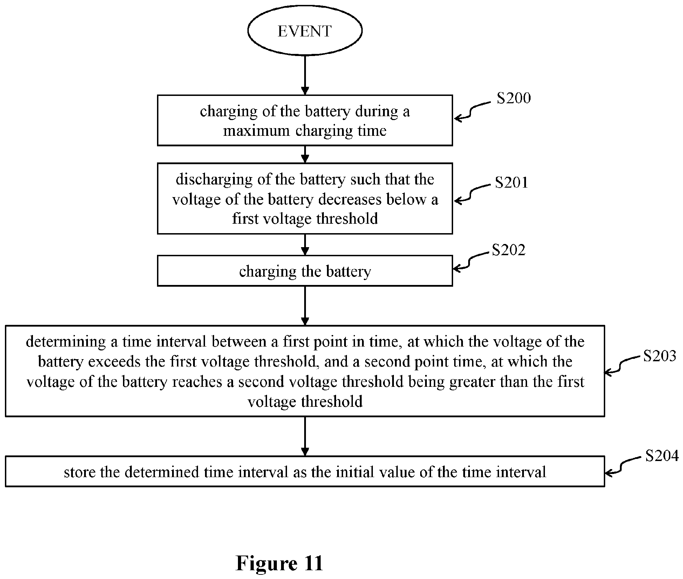

**FIG. 11** shows an example of a method according to an embodiment of the invention for testing a life-time of a battery being an emergency electrical energy storage of an emergency lighting system. FIG. 11 shows optionally method steps of the method of FIG. 10. The description of the method of FIG. 10 is valid for the method of FIG. 11.

As shown in FIG. 11, in response to an event, the method comprises a step S200 of charging the battery for a maximum charging time. The method comprises after the step S200 a step S201 of discharging of the battery such that the voltage of the battery decreases below the first voltage threshold. The method comprises after the step S201 a step S202 of charging the battery. The method comprises a step S203 of determining the time interval during the charging of the battery. The step S203 of the method of FIG. 11 corresponds to the step S102 of the method of FIG. 10. The method comprises after the step S203 a step S204 of storing the determined time interval as the initial value of the time interval.

For further information on the method of FIG. 11 reference is made to the description of the entity of the first aspect, and the description of the method of the third aspect.

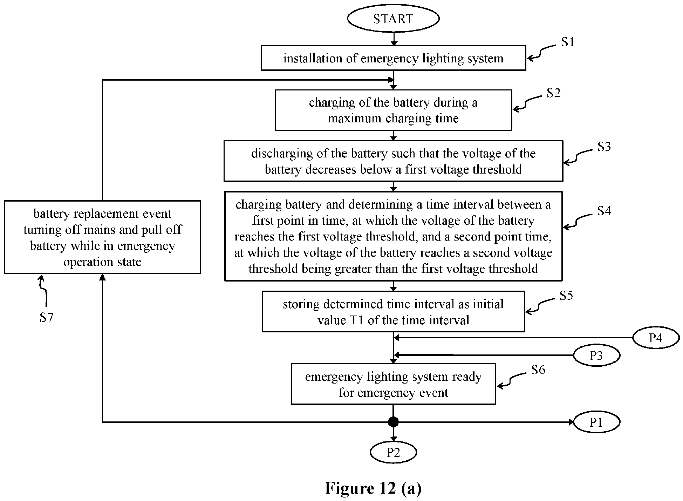

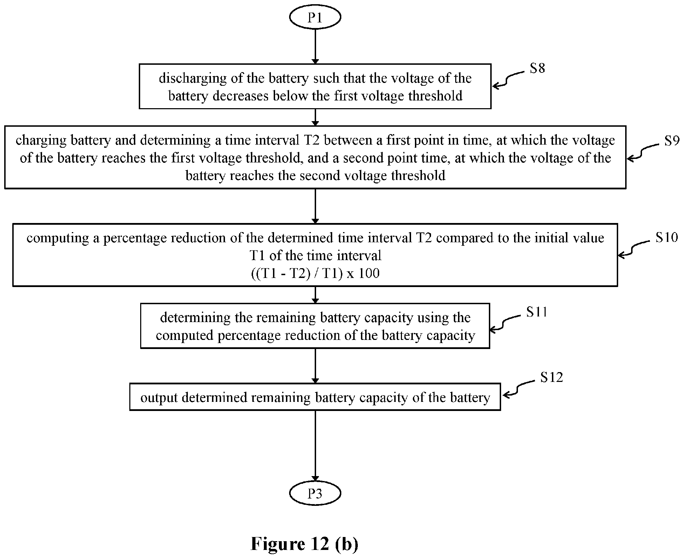

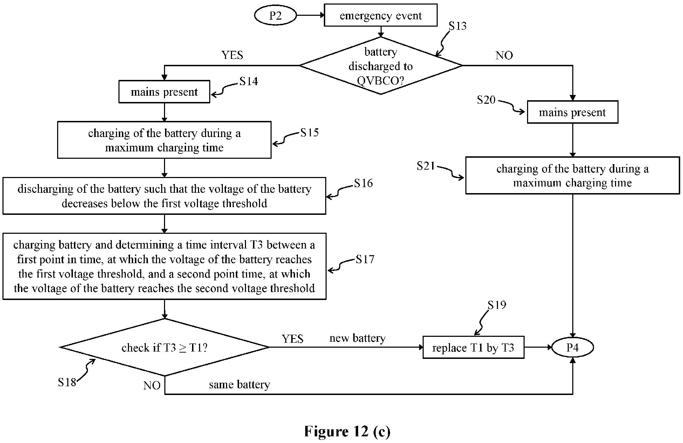

**FIGs. 12 (a)**, **12 (b)** **and** **12(c)** show an example of a method according to an embodiment of the invention for testing a life-time of a battery being an emergency electrical energy storage of an emergency lighting system. The method of FIGs. 12 (a), 12 (b) and 12 (c) is an example of an optional implementation form of the method according to the third aspect of the invention. The description of the method according to the third aspect is correspondingly valid for the method of FIGs. 12 (a), 12 (b) and 12 (c).

As shown in FIG. 12 (a), in a first step S1 the emergency lighting system may be installed, for example for the first time. In a step S2 following the step S1 the battery is charged during a maximum charging time. After the step S2, in a step S3 the battery is discharged such that the voltage of the battery decreases below a first voltage threshold. This step S3 may be performed by performing a duration test of the battery, wherein the duration test is done such that the battery voltage decreases below the first voltage threshold. In case of performing the duration test, the method may proceed to the next step S4 only in case the duration test has been successfully passed. Otherwise, it is indicated, e.g. by the emergency lighting system, that the duration test has failed and, thus, the duration test is to be repeated (in order to exclude the case of a wrongly performed duration test) or the battery is to be replaced. In this case, the process may continue from the step S3 to the step S2 once the battery has been replaced (not shown in FIG. 12 (a)).

In a step S4 after the step S3, the battery may be charged and a time interval may be determined during the charging of the battery. The time interval is a time interval between a first point in time, at which the voltage of the battery exceeds the first voltage threshold, and a second point in time, at which the voltage of the battery reaches a second voltage threshold being greater than the first voltage threshold. In a step S5 after the step S4 the determined time interval is stored as an initial value T1 of the time interval. After the step S5 the emergency lighting system is ready for an emergency event (i.e. ready to operate in the emergency operation state), as indicted in FIG. 12 (a) by the state S6.

As indicated in FIG. 12 (a), in case a battery replacement event takes place (e.g. turning off mains and, thus, pull off the battery while the emergency lighting system is in the emergency operation state) the process may return to step S2 and, thus, the steps S2 to S5 may be repeated. The battery replacement event is indicated in FIG. 12(a) as a step S7.

When the emergency lighting system is in the state S6 and, thus ready for an emergency event the process may continue in two ways, wherein a first way is indicated by the circle "P1" and is shown in FIG. 12 (b) and a second way is indicated by the circle "P2" and is shown in FIG. 12 (c).

As shown in FIG. 12 (b), in a step S8 the battery may be discharged such that the battery voltage decreases below the first voltage threshold. This step S8 may be performed by performing a duration test of the battery, wherein the duration test is done such that the battery voltage decreases below the first voltage threshold. In case of performing the duration test, the method may proceed to the next step S9 only in case the duration test has been passed successfully. Otherwise, it is indicated, e.g. by the emergency lighting system, that the duration test has failed and, thus, the duration test is to be repeated (in order to exclude the case of a wrongly performed duration test) or the battery is to be replaced. In this case, the process may continue from the step S8 to the step S2 once the battery has been replaced (not shown in FIG.s 12 (a) and 12 (b)).

In the step S9 following the step S8 the battery is charged and a time interval T2 is determined during the charging of the battery. The time interval T2 is a time interval between a first point in time, at which the voltage of the battery exceeds the first voltage threshold, and a second point in time, at which the voltage of the battery reaches the second voltage threshold being greater than the first voltage threshold. In a step S10 following the step S9 a percentage reduction in the determined time interval T2 compared to the initial value T1 of the time interval is computed (i.e. ((T1 - T2) / T1) × 100). In a step S11 following the step S10, the remaining battery capacity is determined using the computed percentage reduction of the battery capacity. This may be done as described in the description of the entity of the first aspect. Optionally, in the step S11 the remaining life-time of the battery may be determined (e.g. computed) using an extrapolation function and the determined remaining battery capacity and one or more determined remaining battery capacities of the battery determined at one or more past points in time. The one or more past determined remaining battery capacities may be stored in a data storage, such as a non-volatile data storage, of the emergency lighting system. This may provide a "black box" function.

In a step S12 following the step S11 the emergency lighting system may output the determined remaining battery capacity of the battery and optionally the determined remaining life-time of the battery. This may be output via a communication interface (e.g. DALI communication interface), and/or indicator lighting means (e.g. an indicator LED) of the emergency lighting system. In case, the remaining battery capacity is sufficient for an emergency operation of the emergency lighting system, the process may continue after the step S12 to the state S6, in which the emergency lighting system is ready for an emergency event. This is indicated in FIGs. 12 (a) and 12 (b), by the circle "P3". Otherwise, in response to the determined remaining battery capacity being smaller than a threshold value for the battery capacity, the emergency lighting system may output or report the information that the remaining battery capacity is insufficient for an emergency operation of the emergency lighting system. This may be done via a communication interface (e.g. DALI communication interface) and/or indicator lighting means (e.g. indicator LED) of the emergency lighting system. This indicates to a user of the emergency lighting system that the battery should be replaced. In this case, the process may continue from the step S12 to the step S2 once the battery has been replaced (not shown in FIGs. 12 (a) and 12 (b)). The threshold value for the battery capacity may be for example 66% of the initial value of the battery capacity.

As shown in FIG. 12 (c), in case an emergency event has occurred (i.e. the emergency lighting system has operated in the emergency operation state) in a step S13 it is determined whether the battery has discharged down to a quiescent voltage battery cut off (QVBCO) or not. In case this is true (i.e. "YES" at step S13), the step S13 may be followed by a state S14 in which the electrical supply from mains is present again, i.e. the emergency lighting system operates again in the normal operation state. In this state S14 after the step S13, the battery may be charged during a maximum charging time. This corresponds to a step S15. In case the battery has discharged down to a QVBCO, the emergency event and, thus, emergency operation of the emergency lighting system has led to a full discharged of the battery. The step S15 is followed by a step S16, in which the battery may be discharged such that the battery voltage decreases below the first voltage threshold. This step S16 may be performed by performing a duration test of the battery, wherein the duration test is done such that the battery voltage decreases below the first voltage threshold. In case of performing the duration test, the method may proceed to the next step S17 only in case the duration test has been passed successfully. Otherwise, it is indicated, e.g. by the emergency lighting system, that the duration test has failed and, thus, the duration test is to be repeated (in order to exclude the case of a wrongly performed duration test) or the battery is to be replaced. In this case, the process may continue from the step S16 to the step S2 once the battery has been replaced (not shown in FIGs. 12 (a) and 12 (c)).

In a step S17 after the step S16, the battery is charged and a time interval T3 is determined during the charging of the battery. The time interval T3 is a time interval between a first point in time, at which the voltage of the battery exceeds the first voltage threshold, and a second point in time, at which the voltage of the battery reaches the second voltage threshold being greater than the first voltage threshold. In a step S18 after the step S17 it is determined whether the determined time interval T3 is greater or equal to the initial value T1 of the time interval. In case this is true ("YES" at step S18) the battery was replaced by a new battery (e.g. in the state S14) and, thus, the determined time interval T3 is stored as the initial value of the time interval (i.e. T1 is replaced by T3) and the process continues to the state S6, in which the emergency lighting system is ready for an emergency event. This is indicated in FIGs. 12 (a) and 12 (c) by the circle "P4". In case the determined time interval T3 is smaller than the initial value T1 of the time interval ("NO" at step S18) the battery was not replaced, and the process continues to the state S6, in which the emergency lighting system is ready for an emergency event. This is indicated in FIGs. 12 (a) and 12 (c) by the circle "P4".

In case it is determined in step S13 that the battery has not discharged down to a QVBCO ("NO" at step S13), the step S13 may be followed by a state S20 in which the electrical supply from mains is present again, i.e. the emergency lighting system operates again in the normal operation state. In this state S20 after the step S13, the battery may be charged during a maximum charging time. This corresponds to a step S21. From the step S21 the process may continue to the state S6, in which the emergency lighting system is ready for an emergency event. This is indicated in FIGs. 12 (a) and 12 (c) by the circle "P4".

The entity 1 of FIG. 1 may be configured to perform testing steps for testing the life-time of the battery such that any one of the methods of FIGs. 10, 11 and 12 are performed.

All steps which are performed by the various entities described in the present disclosure as well as the functionalities described to be performed by the various entities are intended to mean that the respective entity is adapted to or configured to perform the respective steps and functionalities. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. An entity (1) for testing a life-time of a battery (3) being an emergency electrical energy storage of an emergency lighting system (2), wherein the entity (1) is configured to perform the following testing steps:
- triggering charging of the battery (3) having a voltage smaller than a first voltage threshold (VT1),
- determining a time interval between a first point in time, at which the voltage of the battery exceeds the first voltage threshold (VT1), and a second point in time, at which the voltage of the battery reaches a second voltage threshold (VT2) being greater than the first voltage threshold (VT1), and
- determining a remaining battery capacity of the battery (3) using the determined time interval and an initial value of the time interval.

2. The entity (1) according to claim 1, wherein the testing steps comprises
- triggering discharging of the battery (3) such that the voltage of the battery (3) decreases below the first voltage threshold (VT1), and
- triggering the charging of the battery (3) after the discharging has ended.

3. The entity (1) according to claim 1 or 2, wherein the entity (1) is configured to
- compute a percentage reduction of the battery capacity of the battery (3) with regard to an initial battery capacity of the battery (3) by computing a percentage reduction of the determined time interval compared to the initial value of the time interval, and
- determine the remaining battery capacity using the computed percentage reduction of the battery capacity.

4. The entity (1) according to claim 3, wherein
- the entity (1) is configured to output, in response to the determined remaining battery capacity being smaller than a threshold value for the battery capacity, via
- a communication interface, optional DALI communication interface, and/or
- an indicator lighting means, optional an indicator LED,
the information that the remaining battery capacity is insufficient for an emergency operation of the emergency lighting system (2).

5. The entity (1) according to any one of the previous claims, wherein the entity (1) is configured to
- perform the testing steps at regular repeating points in time, and
- determine a remaining life-time of the battery (3) using an extrapolation function and two or more determined remaining battery capacities of the battery (3) determined at two or more points in time of the regular repeating points in time.

6. The entity (1) according to any one of the previous claims, wherein
- the entity (1) may be configured to trigger the charging of the battery (3) having the voltage smaller than the first voltage threshold (VT1) such that the battery (3) is charged in a constant current charging phase.

7. The entity (1) according to any one of the previous claims, wherein
- the second voltage threshold (VT2) equals to a voltage at which a constant current charging phase stops and a constant voltage charging phase is started during the charging of the battery (3).

8. The entity (1) according to any one of the previous claims, wherein
- the entity (1) is configured to perform the testing steps every six months and/or every year.

9. The entity (1) according to any one of the previous claims, wherein the entity (1) is configured to, in response to an event, perform the following second type testing steps:
- triggering charging of the battery (3) for a maximum charging time,
- triggering, after the battery (3) has been charged for the maximum charging time, discharging of the battery (3) such that the voltage of the battery decreases below the first voltage threshold (VT1),
- triggering charging the battery (3) after the discharging has ended,
- determining the time interval, and
- storing the determined time interval as the initial value of the time interval.

10. The entity (1) according to claim 9, wherein the event is one of
- an installation of the emergency lighting system (2),
- the battery (3) is removed from the emergency lighting system (2) while mains supply (8) of the emergency lighting system (2) is present and the removed battery (3) or a new battery is provided as the emergency electrical energy storage of the emergency lighting system (2),
- the battery (3) or a new battery is provided as the emergency electrical energy storage of the emergency lighting system (2) after the emergency lighting system (2) is powered on while no battery is present as the emergency electrical energy storage of the emergency lighting system (2) and mains supply (8) of the emergency lighting system (2) is present,
- the battery (3) or a new battery is provided as the emergency electrical energy storage to the emergency lighting system (2) after the battery (3) has been removed in an emergency operation state of the emergency lighting system (2) and mains supply (8) of the emergency lighting system (2) has recovered, and
- the battery (3) or a new battery is provided as the emergency electrical energy storage to the emergency lighting system (2) after the battery (3) has been discharged down to a quiescent voltage battery cut off in the emergency operation state of the emergency lighting system (2) and mains supply (8) of the emergency lighting system (2) has recovered.

11. The entity (1) according to claim 9 or 10, wherein the entity (1) is configured to
- compare the determined time interval with the initial value of the time interval, and
- store the determined time interval as the initial value of the time interval in case the determined time interval is greater than or equal to the initial value of the time interval.

12. An emergency lighting system (2) comprising
- a battery (3) as an emergency electrical energy storage,
- an electrical supply circuit (5) for electrically supplying a light source (6) from one of the battery (3) and a connector (7) for being electrically connected with mains (8), and
- an entity (1) according to any one of the previous claims, wherein
- the entity (1) is configured to test the life-time of the battery (3).

13. The emergency lighting system (2) according to claim 12, wherein the emergency lighting system (2) is
- an emergency luminaire comprising the light source (6) electrically connected to the electrical supply circuit (5), or
- an emergency lighting driver configured to be electrically connected to the light source (6).

14. The emergency lighting system (2) according to claim 12 or 13, wherein
- the emergency lighting system (2) comprises a communication interface, optional DALI communication interface, and the entity (1) is configured to provide information to outside the emergency lighting system (2) via the communication interface; and/or
- the emergency lighting system (2) comprises indicator lighting means, optional an indicator LED, and the entity (1) is configured to provide information to outside the emergency lighting system (2) via the indicator lighting means.

15. A method for testing a life-time of a battery being an emergency electrical energy storage of an emergency lighting system, the method comprising the steps of
- charging (S101) the battery having a voltage smaller than a first voltage threshold,
- determining (S102) a time interval between a first point in time, at which the voltage of the battery exceeds the first voltage threshold, and a second point time, at which the voltage of the battery reaches a second voltage threshold being greater than the first voltage threshold, and
- determining (S103) a remaining battery capacity of the battery using the determined time interval and an initial value of the time interval.
